# EUROPEAN PATENT APPLICATION

(11) **EP 4 177 643 A1**
(43) Date of publication of application: **10.05.2023**
(21) Application number: 21833596.6
(22) Date of filing: 12.05.2021
(51) Int. Cl.: G01T 1/20, H04N 5/32, H04N 5/357

(54) **RADIATION DETECTOR**

(30) Priority: 01.07.2020 JP 2020113832
(71) Applicant: Canon Electron Tubes & Devices Co., Ltd., Otawara-shi, Tochigi 324-0036 (JP)
(72) Inventor: MIBUKA, Ryo, Otawara-shi, Tochigi 324-0036 (JP); ONIHASHI, Hiroshi, Otawara-shi, Tochigi 324-0036 (JP); WAKAMATSU, Shunsuke, Otawara-shi, Tochigi 324-0036 (JP)
(74) Representative: Henkel & Partner mbB
(86) International application number: PCT/JP2021/018041
(87) International publication number: WO 2022/004142

(57) **Abstract**

This radiation detector is provided with: multiple control lines which extend in a first direction; multiple data lines which extend in a second direction perpendicular to the first direction; photoelectric conversion units which are arranged in each of multiple regions partitioned by the control lines and the data lines; multiple noise detectors which are arranged side-by-side outside of the regions where the multiple photoelectric conversion units are arranged; and a scintillator which is provided above the regions where the multiple photoelectric conversion units are arranged. Each of the multiple photoelectric conversion units comprises: a first thin-film transistor which is electrically connected to the corresponding control line and the corresponding data line; and a photoelectric conversion element which has an electrode electrically connected to the first thin-film transistor. Each of the multiple noise detectors comprises: a second thin-film transistor which is electrically connected to the corresponding control line and the corresponding data line; and a capacitance which is electrically connected to the second thin-film transistor. The capacitance unit is shorter than the electrode in the first direction and/or the second direction.

## Description

### [Technical Field]

Embodiments of the invention relate to a radiation detector.

### [Background Art]

An X-ray detector is an example of a radiation detector. The X-ray detector includes, for example, an array substrate that includes multiple photoelectric conversion parts, and a scintillator that is located on the multiple photoelectric conversion parts and converts X-rays into fluorescence. Also, the photoelectric conversion part includes a photoelectric conversion element that converts the fluorescence from the scintillator into a signal charge, a thin film transistor that switches between storing and discharging the signal charge, a storage capacitor that stores the signal charge, etc.

Generally, an X-ray detector configures an X-ray image as follows. First, the incidence of X-rays is recognized by a signal input from the outside. Then, after a predetermined amount of time has elapsed, the thin film transistors of the photoelectric conversion parts that perform reading are set to the on-state, and the stored signal charge is read as an image data signal. Then, the X-ray image is configured based on the values of the image data signals read from the photoelectric conversion parts.

However, values that correspond to the dose of the X-rays and values that correspond to noise are included in the values of the image data signals read from the photoelectric conversion parts. Therefore, when configuring the X-ray image, offset processing (an offset correction) is performed in which the values corresponding to the noise are subtracted from the values of the image data signals read from the photoelectric conversion parts.

In such a case, noise can be broadly divided into random noise and lateral noise. Random noise occurs in a uniform distribution over the entire X-ray image. On the other hand, lateral noise appears as a striation in the lateral direction or the longitudinal direction. Therefore, lateral noise is more noticeable than random noise; it is therefore desirable to reduce lateral noise.

To reduce such lateral noise, technology has been proposed in which multiple noise detecting parts that do not generate signal charges when X-rays are incident are included, and the lateral noise is detected by the multiple noise detecting parts. Generally, the multiple noise detecting parts are arranged outside the region (the effective pixel region) in which the multiple photoelectric conversion parts are located.

Here, in recent years, it is desirable to downsize X-ray detectors. However, a problem results in which the X-ray detector size increases when there is a region outside the effective pixel region in which multiple noise detecting parts are located.

It is therefore desirable to develop technology that can detect noise and can suppress an X-ray detector size increase.

### [Prior Art Documents]

### [Patent Literature]

[Patent Document 1]
JP-A 2011-97452 (Kokai)

### [Summary of Invention]

### [Technical Problem]

A problem to be solved by the invention is to provide a radiation detector that can detect noise and can suppress a radiation detector size increase.

### [Solution to Problem]

A radiation detector according to an embodiment includes multiple control lines extending in a first direction, multiple data lines extending in a second direction orthogonal to the first direction, photoelectric conversion parts located respectively in multiple regions defined by the multiple control lines and the multiple data lines, multiple noise detecting parts arranged outside a region in which the multiple photoelectric conversion parts are located, and a scintillator located on the region in which the multiple photoelectric conversion parts are located.

Each of the multiple photoelectric conversion parts includes a first thin film transistor electrically connected to a corresponding control line of the multiple control lines and a corresponding data line of the multiple data lines, and a photoelectric conversion element including an electrode electrically connected with the first thin film transistor.

Each of the multiple noise detecting parts includes a second thin film transistor electrically connected to a corresponding control line of the multiple control lines and a corresponding data line of the multiple data lines, and a capacitance part electrically connected with the second thin film transistor.

A length of the capacitance part is less than a length of the electrode in at least one of the first direction or the second direction.

### [Brief Description of Drawings]

[FIG. 1]

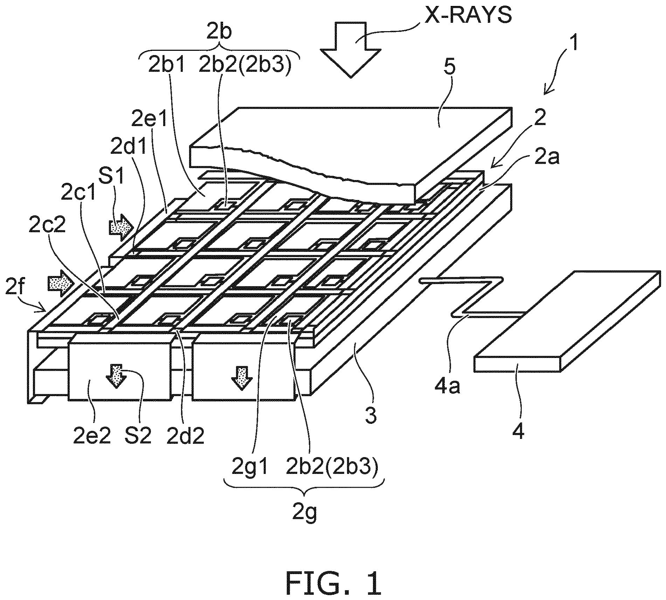

   FIG. 1 is a schematic perspective view illustrating an X-ray detector.
[FIG. 2]

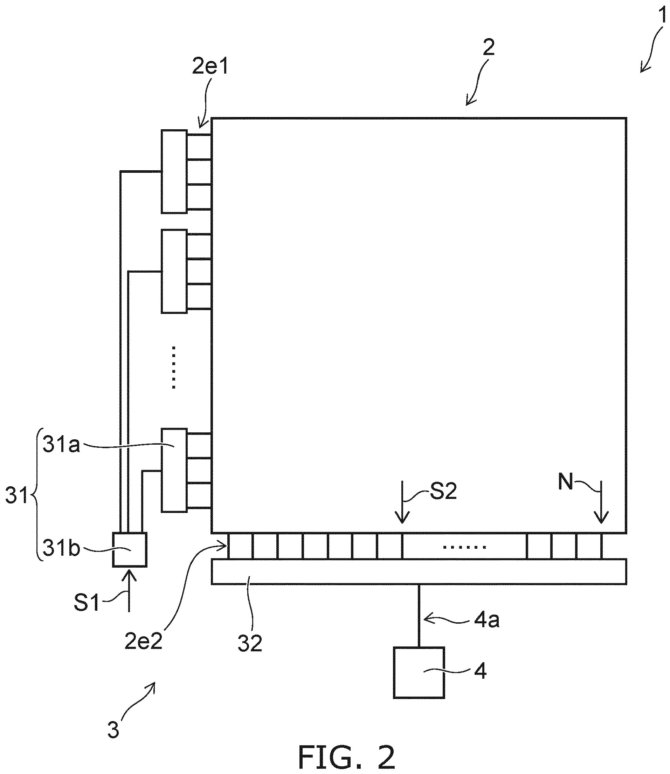

   FIG. 2 is a block diagram of the X-ray detector.
[FIG. 3]

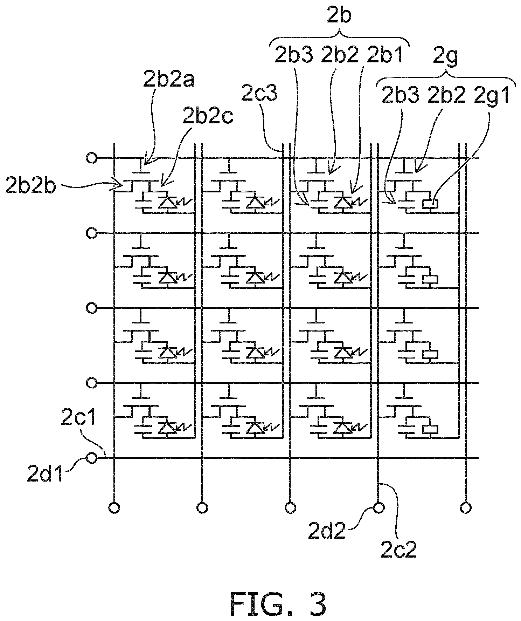

   FIG. 3 is a circuit diagram of an array substrate.
[FIG. 4]

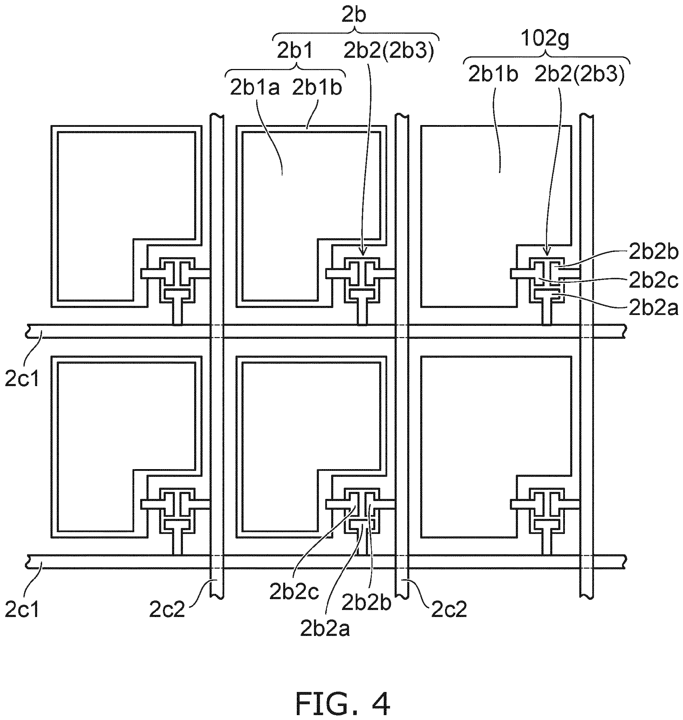

   FIG. 4 is a schematic plan view illustrating a noise detecting part according to a comparative example.
[FIG. 5]

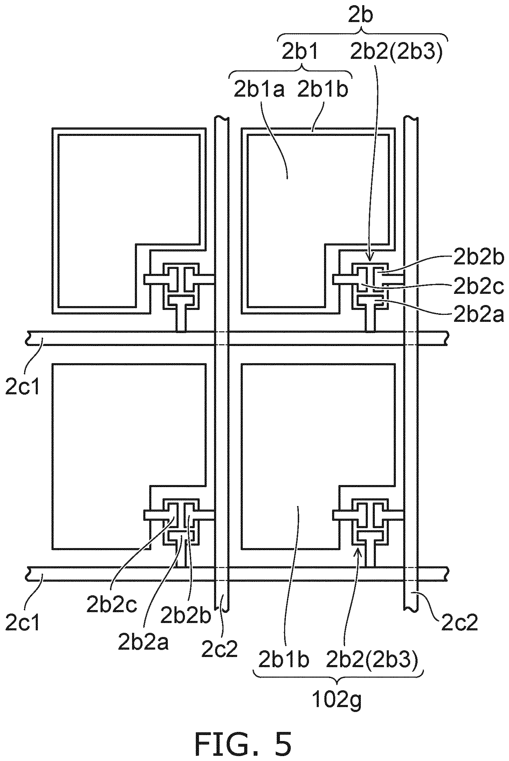

   FIG. 5 is a schematic plan view illustrating the noise detecting part according to the comparative example.
[FIG. 6]

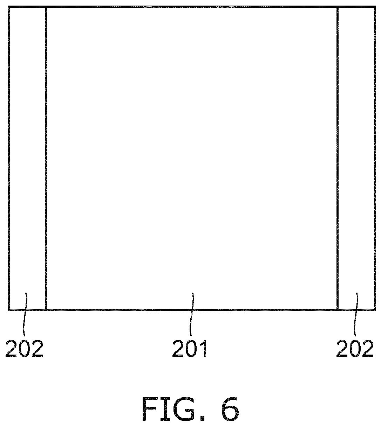

   FIG. 6 is a schematic plan view illustrating the location of a region in which the multiple noise detecting parts are located.
[FIG. 7]

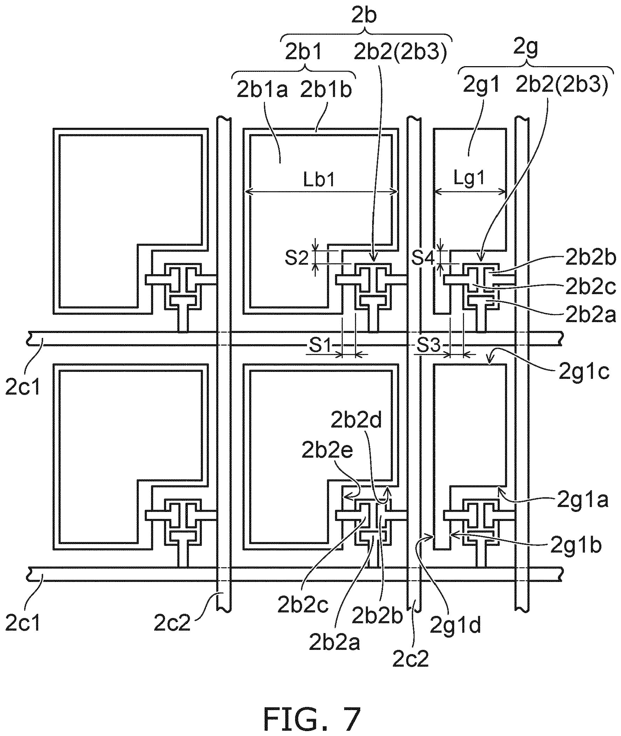

   FIG. 7 is a schematic plan view illustrating the noise detecting part according to the embodiment.
[FIG. 8]

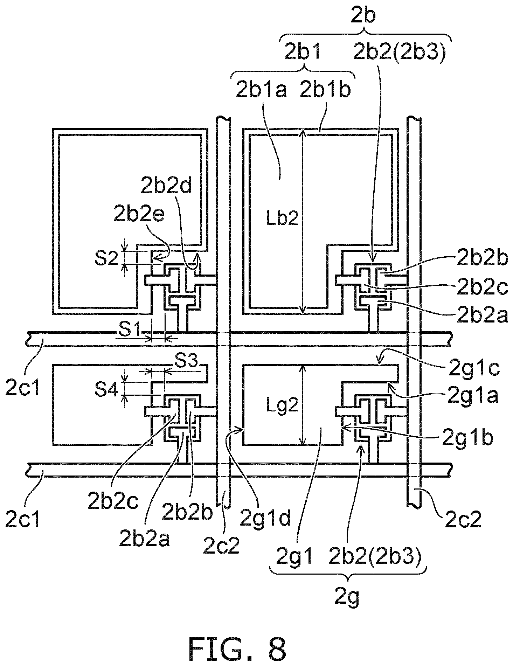

   FIG. 8 is a schematic plan view illustrating the noise detecting part according to the embodiment.
[FIG. 9]

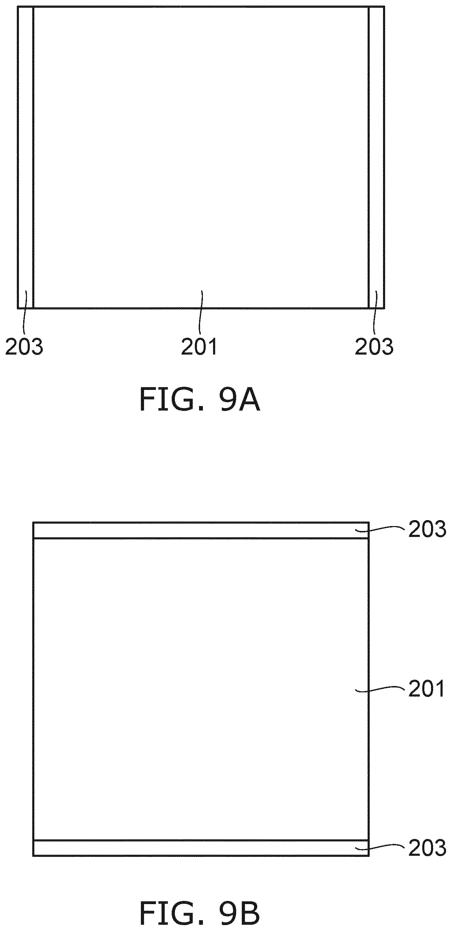

   FIGS. 9A and 9B are schematic plan views for illustrating the location of a region in which the multiple noise detecting parts are located.
[FIG. 10]

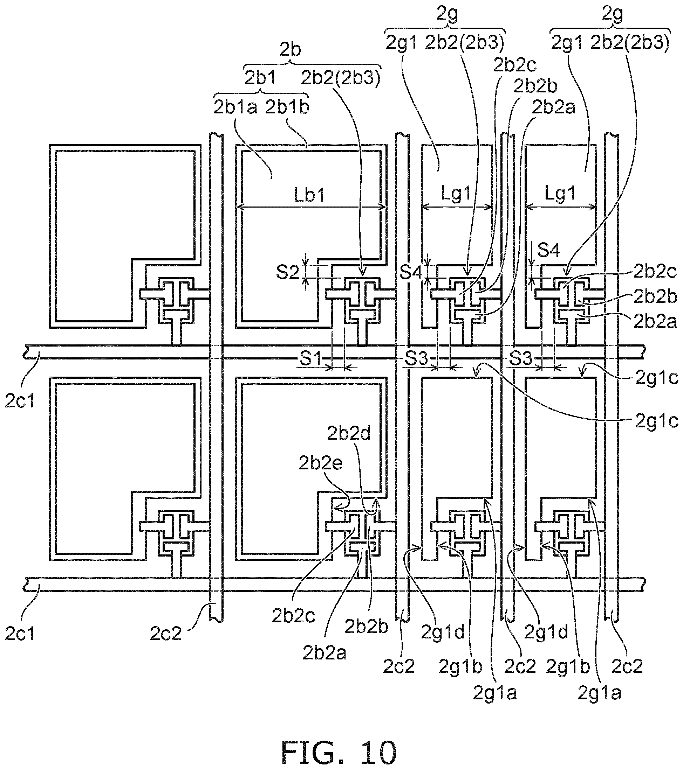

   FIG. 10 is a schematic plan view illustrating an arrangement of noise detecting parts according to another embodiment.
[FIG. 11]

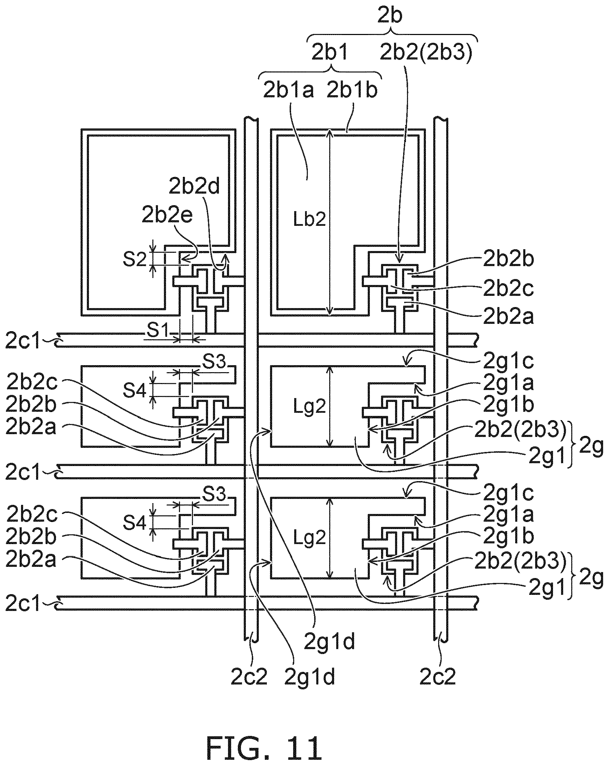

   FIG. 11 is a schematic plan view illustrating the arrangement of noise detecting parts according to another embodiment.
[FIG. 12]

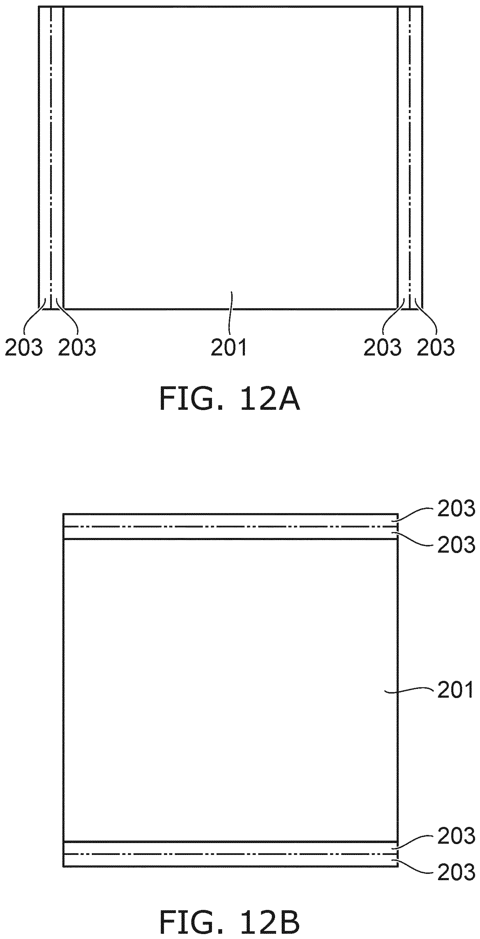

   FIGS. 12A and 12B are schematic plan views for illustrating locations of the region 203.

### [Description of Embodiments]

Embodiments will now be illustrated with reference to the drawings. Similar components in the drawings are marked with the same reference numerals; and a detailed description is omitted as appropriate.

A radiation detector according to the embodiment is applicable to various radiation other than X-rays such as γ-rays, etc. Herein, as an example, the case relating to X-rays is described as a typical example of radiation. Accordingly, applications to other radiation also are possible by replacing "X-ray" of embodiments described below with "other radiation".

An X-ray detector 1 illustrated below is an X-ray planar sensor that detects an X-ray image, i.e., a radiation image.

For example, the X-ray detector 1 can be used in general medical care, etc., but is not limited in its application.

FIG. 1 is a schematic perspective view illustrating the X-ray detector 1.

A bias line 2c3 and the like are not illustrated in FIG. 1.

FIG. 2 is a block diagram of the X-ray detector 1.

FIG. 3 is a circuit diagram of an array substrate 2.

As shown in FIGS. 1 to 3, the X-ray detector 1 includes the array substrate 2, a signal processing circuit 3, an image configuration circuit 4, and a scintillator 5.

The array substrate 2 converts, into an electrical signal, fluorescence (visible light) converted from X-rays by the scintillator 5.

The array substrate 2 includes a substrate 2a, a photoelectric conversion part 2b, a control line (or gate line) 2c1, a data line (or signal line) 2c2, the bias line 2c3, and a noise detecting part 2g.

The numbers and the like of the photoelectric conversion part 2b, the control line 2c1, the data line 2c2, the bias line 2c3, and the noise detecting part 2g are not limited to those illustrated.

The substrate 2a is plate-shaped and formed from a light-transmitting material such as alkali-free glass, etc.

Multiple photoelectric conversion parts 2b are located at one surface of the substrate 2a.

The photoelectric conversion parts 2b are rectangular and are located respectively in multiple regions defined by the multiple control lines 2c1 and the multiple data lines 2c2. The multiple photoelectric conversion parts 2b are arranged in a matrix configuration.

One photoelectric conversion part 2b corresponds to one pixel (pixel) of the X-ray image.

Each of the multiple photoelectric conversion parts 2b includes a photoelectric conversion element 2b1 and a thin film transistor (TFT; Thin Film Transistor) 2b2 (corresponding to an example of a first thin film transistor) that is a switching element.

Also, as shown in FIG. 3, a storage capacitor 2b3 that stores the signal charge converted by the photoelectric conversion element 2b1 can be included. The storage capacitor 2b3 is, for example, rectangular flat-plate shaped and can be located under each thin film transistor 2b2. However, according to the capacitance of the photoelectric conversion element 2b1, the photoelectric conversion element 2b1 also can be used as the storage capacitor 2b3.

The photoelectric conversion element 2b1 can be, for example, a photodiode, etc. The thin film transistor 2b2 switches between storing and discharging the charge generated by fluorescence incident on the photoelectric conversion element 2b1. The thin film transistor 2b2 includes a gate electrode 2b2a, a drain electrode 2b2b, and a source electrode 2b2c. The gate electrode 2b2a of the thin film transistor 2b2 is electrically connected with the corresponding control line 2c1. The drain electrode 2b2b of the thin film transistor 2b2 is electrically connected with the corresponding data line 2c2. The source electrode 2b2c of the thin film transistor 2b2 is electrically connected to the corresponding photoelectric conversion element 2b1 (electrode 2b1b) and storage capacitor 2b3. Also, the storage capacitor 2b3 and the anode side of the photoelectric conversion element 2b1 are electrically connected with the corresponding bias line 2c3. In other words, the thin film transistor 2b2 is electrically connected to the corresponding control line 2c1 and the corresponding data line 2c2. The electrode 2b1b at the substrate 2a side of the photoelectric conversion element 2b1 is electrically connected with the thin film transistor 2b2 (see FIGS. 7 and 8).

Multiple control lines 2c1 are arranged parallel to each other at a prescribed spacing. For example, the control lines 2c1 extend in a row direction (corresponding to an example of a first direction).

One control line 2c1 is electrically connected with one of multiple wiring pads 2d1 located at the peripheral edge vicinity of the substrate 2a. One of multiple interconnects provided in a flexible printed circuit board 2e1 is electrically connected to one wiring pad 2d1. The other ends of the multiple interconnects provided in the flexible printed circuit board 2e1 are electrically connected with a control circuit 31 included in the signal processing circuit 3.

Multiple data lines 2c2 are arranged parallel to each other at a prescribed spacing. For example, the data lines 2c2 extend in a column direction (corresponding to an example of a second direction) orthogonal to the row direction.

One data line 2c2 is electrically connected with one of multiple wiring pads 2d2 located at the peripheral edge vicinity of the substrate 2a. One of multiple interconnects provided in a flexible printed circuit board 2e2 is electrically connected to one wiring pad 2d2. The other ends of the multiple interconnects provided in the flexible printed circuit board 2e2 are electrically connected with a signal detection circuit 32 included in the signal processing circuit 3.

The bias line 2c3 is provided parallel to the data line 2c2 between the data line 2c2 and the data line 2c2.

A not-illustrated bias power supply is electrically connected to the bias line 2c3. For example, a not-illustrated bias power supply can be included in the signal processing circuit 3, etc.

The bias line 2c3 is not always necessary and may be included as necessary. When the bias line 2c3 is not included, the storage capacitor 2b3 and the anode side of the photoelectric conversion element 2b1 are electrically connected to ground instead of the bias line 2c3.

For example, the control line 2c1, the data line 2c2, and the bias line 2c3 can be formed using a low-resistance metal such as aluminum, chrome, etc.

A protective layer 2f covers the photoelectric conversion part 2b, the control line 2c1, the data line 2c2, and the bias line 2c3.

The protective layer 2f includes, for example, at least one of an oxide insulating material, a nitride insulating material, an oxynitride insulating material, or a resin material.

Multiple noise detecting parts 2g are provided as shown in FIG. 3. The multiple noise detecting parts 2g are arranged outside the region (the effective pixel region) in which the multiple photoelectric conversion parts 2b are located. The multiple noise detecting parts 2g are arranged along at least one of the control line 2c1 or the data line 2c2. For example, as shown in FIG. 3, the multiple noise detecting parts 2g can be arranged along the data line 2c2. In such a case, for example, the multiple noise detecting parts 2g also can be arranged along the control line 2c1. For example, the multiple noise detecting parts 2g also can be arranged along the control line 2c1 and the data line 2c2.

Although the multiple noise detecting parts 2g are located at one outer side of the effective pixel region in the illustration of FIG. 3, the multiple noise detecting parts 2g may be located at two outer sides, three outer sides, or four outer sides of the effective pixel region.

Each of the multiple noise detecting parts 2g includes a capacitance part 2g1 and the thin film transistor 2b2 (corresponding to an example of a second thin film transistor). The thin film transistor 2b2 is electrically connected to the corresponding control line 2c1 and the corresponding data line 2c2. The capacitance part 2g1 is electrically connected with the thin film transistor 2b2.

When the photoelectric conversion part 2b includes the storage capacitor 2b3, the storage capacitor 2b3 also can be included in the noise detecting part 2g. For example, the storage capacitor 2b3 can be located under the capacitance part 2g1.

For example, the capacitance part 2g1 can be formed from a conductive material such as a metal, etc. If the capacitance part 2g1 is formed from a conductive material, a signal charge is substantially not generated even when the fluorescence generated by the scintillator 5 is incident on the capacitance part 2g1. For example, the capacitance part 2g1 can be formed from the same material as the electrode 2b1b of the photoelectric conversion element 2b1. For example, the capacitance part 2g1 can be formed using a low-resistance metal such as aluminum, chrome, etc.

The gate electrode 2b2a of the thin film transistor 2b2 included in the noise detecting part 2g is electrically connected with the corresponding control line 2c1. The drain electrode 2b2b of the thin film transistor 2b2 is electrically connected with the corresponding data line 2c2. The source electrode 2b2c of the thin film transistor 2b2 is electrically connected to the corresponding capacitance part 2g1 and storage capacitor 2b3.

Details related to the noise detecting part 2g are described below.

The signal processing circuit 3 is located at the side of the array substrate 2 opposite to the scintillator 5 side.

As shown in FIG. 2, the signal processing circuit 3 includes the control circuit 31 and the signal detection circuit 32.

The control circuit 31 switches between the on-state and the off-state of the thin film transistor 2b2.

The control circuit 31 includes multiple gate drivers 31a and a row selection circuit 31b.

A control signal S1 is input from the image configuration circuit 4 or the like to the row selection circuit 31b. The row selection circuit 31b inputs the control signal S1 to the corresponding gate driver 31a according to the scanning direction of the X-ray image.

The gate driver 31a inputs the control signal S1 to the corresponding control line 2c1.

For example, the control circuit 31 sequentially inputs the control signal S1 via the flexible printed circuit board 2e1 to each control line 2c1.

The thin film transistor 2b2 that is located in the photoelectric conversion part 2b is switched to the on-state by the control signal S1 input to the control line 2c1; and the signal charge (an image data signal S2) from the storage capacitor 2b3 can be received.

When the thin film transistor 2b2 is in the on-state, the signal detection circuit 32 reads the image data signal S2 from the storage capacitor 2b3 via the data line 2c2 and the flexible printed circuit board 2e2 according to the sampling signal from the image configuration circuit 4.

For example, the image data signal S2 can be read as follows.

First, the thin film transistors 2b2 are sequentially set to the on-state by the control circuit 31. By setting the thin film transistor 2b2 to the on-state, a certain charge is stored in the storage capacitor 2b3 via the bias line 2c3. Then, the thin film transistors 2b2 are set to the off-state. When X-rays are irradiated, the X-rays are converted into fluorescence by the scintillator 5. When the fluorescence is incident on the photoelectric conversion element 2b1, a charge (electrons and holes) is generated by the photoelectric effect; the generated charge and the charge (the heterogeneous charge) stored in the storage capacitor 2b3 combine; and the stored charge is reduced. Then, the control circuit 31 sequentially sets the thin film transistors 2b2 to the on-state. The reduced charge (the image data signal S2) stored in each storage capacitor 2b3 is read by the signal detection circuit 32 via the data line 2c2 according to the sampling signal.

Also, when the thin film transistors 2b2 are in the off-state, the signal detection circuit 32 reads the noise current (a noise signal N) from the noise detecting parts 2g via the data line 2c2 and the flexible printed circuit board 2e2.

The image configuration circuit 4 is electrically connected with the signal detection circuit 32 via by an interconnect 4a. The image configuration circuit 4 may be formed to have a continuous body with the signal processing circuit 3 or may perform wireless data communication with the signal detection circuit 32.

The image configuration circuit 4 receives the image data signal S2 that is read, sequentially amplifies the received image data signal S2, and converts the amplified image data signal S2 (an analog signal) into a digital signal. Then, the image configuration circuit 4 configures an X-ray image based on the image data signal S2 converted into the digital signal. The configured X-ray image data is output from the image configuration circuit 4 toward an external device.

The scintillator 5 is located on the region in which the multiple photoelectric conversion parts 2b are located and converts the incident X-rays into fluorescence. The scintillator 5 is provided to cover the effective pixel region on the substrate 2a.

For example, the scintillator 5 can be formed using cesium iodide (CsI):thallium (Tl), sodium iodide (NaI):thallium (Tl), etc. In such a case, the scintillator 5 that is made of an aggregate of multiple columnar crystals is formed by forming the scintillator 5 by using vacuum vapor deposition, etc.

Also, for example, the scintillator 5 can be formed using gadolinium oxysulfide (Gd₂O₂S), etc. In such a case, a quadrilateral prism-shaped scintillator 5 can be provided for each photoelectric conversion part 2b.

Furthermore, a not-illustrated reflective layer can be provided to cover the front side of the scintillator 5 (the X-ray incident surface side) to increase the utilization efficiency of the fluorescence and improve the sensitivity characteristics.

Also, a not-illustrated moisture-resistant body that covers the scintillator 5 and the not-illustrated reflective layer can be provided to suppress the degradation of the characteristics of the scintillator 5 and the characteristics of the not-illustrated reflective layer due to water vapor included in the air.

The noise detecting part 2g will now be described further.

The noise that appears in the X-ray image can be broadly divided into random noise and lateral noise. Random noise occurs in a uniform distribution over the entire X-ray image, and therefore has no specific pattern or contour. In contrast, lateral noise appears as a striation in the lateral direction or the longitudinal direction of the X-ray image. In such a case, because a human views the X-ray image, lateral noise that has patterns and/or contours affects the quality of the X-ray image much more than random noise without patterns or contours. It is therefore desirable to reduce lateral noise of the X-ray detector.

The source of the lateral noise is considered to be mainly the control circuit 31. For example, there are cases where noise generated in the control circuit 31 and/or noise of the power supply line for driving the control circuit 31 enters the control line 2c1. The thin film transistor 2b2 is electrically connected between the control line 2c1 and the data line 2c2. It is therefore considered that noise does not enter the data line 2c2 from the control line 2c1 if the thin film transistor 2b2 is in the off-state. However, the photoelectric conversion element 2b1 is located at the vicinity of the thin film transistor 2b2. Therefore, line-to-line capacitance (stray capacitance) may occur between the thin film transistor 2b2 and the electrode 2b1b of the photoelectric conversion element 2b1; and noise may enter the data line 2c2 from the control line 2c1 due to electrostatic coupling. Lateral noise is generated when noise enters the data line 2c2 from the control line 2c1.

In such a case, the lateral noise can be reduced by reducing the noise generated in the control circuit 31 and the power supply line. However, such noise countermeasures may make the structure of the X-ray detector 1 complex and more expensive.

Therefore, generally, multiple noise detecting parts that detect the lateral noise are provided, and offset processing is performed by subtracting a value corresponding to the detected lateral noise from the value of the image data signal S2 output from each photoelectric conversion part 2b.

FIGS. 4 and 5 are schematic plan views for illustrating a noise detecting part 102g according to a comparative example.

The bias lines 2c3 are not illustrated in FIGS. 4 and 5. As shown in FIGS. 4 and 5, the photoelectric conversion element 2b1 that is included in the photoelectric conversion part 2b includes a semiconductor layer 2b1a having a p-n junction or p-i-n structure, and an electrode 2b1b located at the substrate 2a side of the semiconductor layer 2b1a. The electrode 2b1b is electrically connected with the source electrode 2b2c of the thin film transistor 2b2.

The semiconductor layer 2b1a is not included in the noise detecting part 102g. In other words, the noise detecting part 102g includes the electrode 2b1b, the thin film transistor 2b2, and the storage capacitor 2b3. Because the noise detecting part 102g does not include the semiconductor layer 2b1a, the output from the noise detecting part 102g includes a value corresponding to the noise without including a value corresponding to the dose of the X-rays.

Therefore, an X-ray image in which the lateral noise is suppressed can be obtained by subtracting the value output from the noise detecting part 102g from the value of the image data signal S2 output from each photoelectric conversion part 2b. The value that is used in the offset processing can be the average value of values output from multiple noise detecting parts 102g.

Here, in recent years, it is desirable to downsize the X-ray detector 1. In such a case, the effective pixel region in which the multiple photoelectric conversion parts 2b are located is the region that performs the imaging of the X-ray detector 1, and therefore is difficult to reduce.

Also, the multiple noise detecting parts 102g are arranged outside the effective pixel region. For example, as shown in FIG. 4, there are cases where the multiple noise detecting parts 102g are arranged in the direction in which the data line 2c2 extends. As shown in FIG. 5, there are cases where the multiple noise detecting parts 102g are arranged in the direction in which the control line 2c1 extends. There are also cases where the multiple noise detecting parts 102g are arranged in the direction in which the data line 2c2 extends and the direction in which the control line 2c1 extends.

FIG. 6 is a schematic plan view illustrating the location of a region 202 in which the multiple noise detecting parts 102g are located.

As shown in FIG. 6, the region 202 in which the multiple noise detecting parts 102g are located is positioned outside an effective pixel region 201. In the case of the illustration of FIG. 6, one region 202 is located at each of two sides of the effective pixel region 201.

Therefore, the X-ray detector is larger by the size of the regions 202 included.

Here, the region 202 is not a region that performs the imaging of the X-ray detector 1, and therefore can be reduced as long as the lateral noise can be detected.

Therefore, the region 202 of the X-ray detector 1 according to the embodiment is reduced.

FIGS. 7 and 8 are schematic plan views for illustrating the noise detecting part 2g according to the embodiment.

The bias lines 2c3 are not illustrated in FIGS. 7 and 8.

As shown in FIGS. 7 and 8, the noise detecting part 2g includes the capacitance part 2g1, the thin film transistor 2b2, and the storage capacitor 2b3. Because the capacitance part 2g1 does not include the semiconductor layer 2b1a, the output from the noise detecting part 2g includes a value corresponding to the noise but does not include a value corresponding to the dose of the X-rays.

As described above, when line-to-line capacitance occurs between the thin film transistor 2b2 and the electrode 2b1b of the photoelectric conversion element 2b1, noise enters the data line 2c2 from the control line 2c1 due to electrostatic coupling.

Therefore, an appropriate value of the lateral noise can be detected if the line-to-line capacitance between the capacitance part 2g1 and the thin film transistor 2b2 is about equal to the line-to-line capacitance between the electrode 2b1b and the thin film transistor 2b2.

To generate about the same line-to-line capacitance, it is sufficient to set dimensions S3 and S4 between the capacitance part 2g1 and the thin film transistor 2b2 to be respectively about equal to dimensions S1 and S2 between the electrode 2b1b and the thin film transistor 2b2. In other words, it is sufficient for the gap dimension between the capacitance part 2g1 and the thin film transistor 2b2 included in the noise detecting part 2g to be substantially equal to the gap dimension between the electrode 2b1b and the thin film transistor 2b2 included in the photoelectric conversion part 2b. Substantially the same or equal means that differences of about the manufacturing error are acceptable.

In such a case, it is favorable for the material of the capacitance part 2g1 to be the same as the material of the electrode 2b1b. It is favorable for the thickness of the capacitance part 2g1 to be about equal to the thickness of the electrode 2b1b.

Also, it is favorable for the lengths of sides 2g1a and 2g1b of the capacitance part 2g1 at the sides facing the thin film transistor 2b2 to be about equal to the lengths of sides 2b2d and 2b2e of the electrode 2b1b at the sides facing the thin film transistor 2b2.

However, the position of a side 2g1c of the capacitance part 2g1 that faces the side 2g1a and the position of a side 2g1d of the capacitance part 2g1 that faces the side 2g1b have little effect on the line-to-line capacitance.

Therefore, when the multiple noise detecting parts 2g are arranged along the data line 2c2 as shown in FIG. 7, a length Lg1 of the capacitance part 2g1 in a direction orthogonal to the direction in which the data line 2c2 extends can be less than a length Lb1 of the electrode 2b1b in the direction orthogonal to the direction in which the data line 2c2 extends.

Also, when the multiple noise detecting parts 2g are arranged along the control line 2c1 as shown in FIG. 8, a length Lg2 of the capacitance part 2g1 in a direction orthogonal to the direction in which the control line 2c1 extends can be less than a length Lb2 of the electrode 2b1b in the direction orthogonal to the direction in which the control line 2c1 extends.

Although a case where the length Lg1 or the length Lg2 is reduced is illustrated above, the length Lg1 and the length Lg2 also can be reduced.

In other words, the length of the capacitance part 2g1 is less than the length of the electrode 2b1b in at least one of the direction in which the control line 2c1 extends or the direction in which the data line 2c2 extends.

The capacitance part 2g1 may be the electrode 2b1b with a portion removed. Thus, the multiple capacitance parts 2g1 and the multiple electrodes 2b1b can be formed in the same process; therefore, the productivity can be increased, and the manufacturing cost can be reduced.

FIGS. 9A and 9B are schematic plan views for illustrating the location of a region 203 in which the multiple noise detecting parts 2g are located.

As shown in FIGS. 9A and 9B, the region 203 in which the multiple noise detecting parts 2g are located can be located outside the effective pixel region 201.

For example, FIG. 9A is the case illustrated in FIG. 7, that is, the case where the multiple noise detecting parts 2g are arranged along the data line 2c2. In such a case, for example, as shown in FIG. 9A, one region 203 in which the multiple noise detecting parts 2g are located can be located at each of the two sides of the effective pixel region 201 in the direction in which the multiple data lines 2c2 are arranged.

For example, FIG. 9B is the case illustrated in FIG. 8, that is, the case where the multiple noise detecting parts 2g are arranged along the control line 2c1. In such a case, for example, as shown in FIG. 9B, one region 203 in which the multiple noise detecting parts 2g are located can be located at each of the two sides of the effective pixel region 201 in the direction in which the multiple control lines 2c1 are arranged.

Thus, as shown in FIG. 9A, the X-ray detector 1 becomes larger by the amount of the region 203 that is included. However, as shown in FIG. 7, the length Lg1 of the capacitance part 2g1 in the direction orthogonal to the direction in which the data line 2c2 extends is less than the length Lb1 of the electrode 2b1b in the direction orthogonal to the direction in which the data line 2c2 extends. Therefore, the region 203 can be smaller than the region 202 according to the comparative example.

Also, as shown in FIG. 9B, the X-ray detector 1 becomes larger by the amount of the region 203 included. However, as shown in FIG. 8, the length Lg2 of the capacitance part 2g1 in the direction orthogonal to the direction in which the control line 2c1 extends is less than the length Lb2 of the electrode 2b1b in the direction orthogonal to the direction in which the control line 2c1 extends. Therefore, the region 203 can be smaller than the region 202 according to the comparative example.

Also, one region 203 can be located at one side of the effective pixel region 201 in the direction in which the multiple data lines 2c2 are arranged or the direction in which the multiple control lines 2c1 are arranged.

Thus, the noise can be detected, and the X-ray detector 1 size increase can be further suppressed.

Also, one region 203 can be located at each of the two sides of the effective pixel region 201 in the direction in which the multiple data lines 2c2 are arranged and the direction in which the multiple control lines 2c1 are arranged. In other words, the region 203 can be provided to surround the effective pixel region 201. In such a case as well, the region 203 can be smaller than the region 202 according to the comparative example.

As described above, the region 203 can be located on at least one side of the effective pixel region 201.

As described above, the value that is used in the offset processing can be the average value of the values output from the multiple noise detecting parts 2g. Therefore, by increasing the number of the noise detecting parts 2g, the noise can be detected with high accuracy, which in turn can increase the accuracy of the lateral noise removal. In such a case, the number of the noise detecting parts 2g can be increased by increasing the number of the regions 203.

If, however, the number of the regions 203 is increased, the X-ray detector 1 will become larger commensurately. However, as described above, the region 203 can be smaller than the region 202 according to the comparative example. Therefore, even when the number of the regions 203 is increased, the X-ray detector 1 size increase can be suppressed. The number and arrangement of the regions 203 can be appropriately determined according to the specifications of the X-ray detector 1, etc.

According to the X-ray detector 1 according to the embodiment as described above, the lateral noise can be detected. Also, the region 203 in which the multiple noise detecting parts 2g are located can be reduced. Therefore, the noise can be detected, and the X-ray detector 1 size increase can be suppressed.

Here, as described above, the value that is used in the offset processing can be the average value of values output from the multiple noise detecting parts 2g. Therefore, by increasing the number of the noise detecting parts 2g, the noise can be detected with high accuracy, which in turn can increase the accuracy of the lateral noise removal.

For example, multiple noise detecting parts 2g can be electrically connected to each of the multiple data lines 2c2. For example, multiple noise detecting parts 2g can be electrically connected to each of the multiple control lines 2c1. In other words, the multiple regions 203 can be arranged. Thus, because the number of the noise detecting parts 2g can be increased, the noise can be detected with high accuracy, which in turn can increase the accuracy of the lateral noise removal.

FIGS. 10 and 11 are schematic plan views for illustrating arrangements of the noise detecting part 2g according to other embodiments.

The bias lines 2c3 are not illustrated in FIGS. 10 and 11.

FIGS. 12A and 12B are schematic plan views for illustrating locations of the region 203.

As shown in FIG. 10, for example, multiple noise detecting parts 2g can be electrically connected to each of two data lines 2c2. In such a case, for example, as shown in FIG. 12A, two regions 203 can be located at each of the two sides of the effective pixel region 201 in the direction in which the multiple data lines 2c2 are arranged. Or, for example, two regions 203 can be located at one side of the effective pixel region 201 in the direction in which the multiple data lines 2c2 are arranged.

As shown in FIG. 11, for example, multiple noise detecting parts 2g can be electrically connected to each of two control lines 2c1. In such a case, for example, as shown in FIG. 12B, two regions 203 can be located at each of the two sides of the effective pixel region 201 in the direction in which the multiple control lines 2c1 are arranged. Also, for example, two regions 203 can be located at one side of the effective pixel region 201 in the direction in which the multiple control lines 2c1 are arranged.

Also, two regions 203 can be located at two sides of the effective pixel region 201 in the direction in which the multiple data lines 2c2 are arranged and the direction in which the multiple control lines 2c1 are arranged. In other words, double regions 203 can be provided to surround the effective pixel region 201.

Although a case is illustrated where two regions 203 are located on at least one side of the effective pixel region 201, the regions 203 can be located on at least three sides.

For example, the multiple data lines 2c2 to which the thin film transistor 2b2 (the second thin film transistors) included in the multiple noise detecting parts 2g are electrically connected can be arranged adjacently in the first direction outside the region (the effective pixel region 201) in which the multiple photoelectric conversion parts 2b are located.

For example, the multiple control lines 2c1 to which the thin film transistor 2b2 (the second thin film transistors) included in the multiple noise detecting parts 2g are electrically connected can be arranged adjacently in the second direction outside the region (the effective pixel region 201) in which the multiple photoelectric conversion parts 2b are located.

However, when the number of the regions 203 is increased, the X-ray detector 1 becomes larger commensurately. However, as described above, the region 203 can be smaller than the region 202 according to the comparative example. Therefore, even when the number of the regions 203 is increased, the X-ray detector 1 size increase can be suppressed. The number and arrangement of the regions 203 can be appropriately determined according to the specifications of the X-ray detector 1, etc.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments herein may be made without departing from the spirit of the inventions. The accompanying claims and their equivalents are intended to cover such forms or modifications as would fall within the scope and spirit of the inventions. Moreover, above-mentioned embodiments can be combined mutually and can be carried out.

### [Reference Numeral List]

1 X-ray detector
2 array substrate
2a substrate
2b photoelectric conversion part
2b1 photoelectric conversion element
2b1a semiconductor layer
2b1b electrode
2b2 thin film transistor
2c1 control line
2c2 data line
2g noise detecting part
2g1 capacitance part
3 signal processing circuit
4 image configuration circuit
5 scintillator
31 control circuit
32 signal detection circuit

## Claims

1. A radiation detector, comprising:
a plurality of control lines extending in a first direction;
a plurality of data lines extending in a second direction orthogonal to the first direction;
photoelectric conversion parts located respectively in a plurality of regions defined by the plurality of control lines and the plurality of data lines;
a plurality of noise detecting parts arranged outside a region in which the plurality of photoelectric conversion parts is located; and
a scintillator located on the region in which the plurality of photoelectric conversion parts is located,
each of the plurality of photoelectric conversion parts including
a first thin film transistor electrically connected to a corresponding control line of the plurality of control lines and a corresponding data line of the plurality of data lines, and
a photoelectric conversion element including an electrode electrically connected with the first thin film transistor,
each of the plurality of noise detecting parts including
a second thin film transistor electrically connected to a corresponding control line of the plurality of control lines and a corresponding data line of the plurality of data lines, and
a capacitance part electrically connected with the second thin film transistor,
a length of the capacitance part being less than a length of the electrode in at least one of the first direction or the second direction.

2. The radiation detector according to claim 1, wherein
a plurality of the second thin film transistors is electrically connected to the plurality of data lines, and
the plurality of data lines are located adjacent to each other in the first direction outside the region in which the plurality of photoelectric conversion parts is located.

3. The radiation detector according to claim 1 or 2, wherein
a plurality of the second thin film transistors is electrically connected to at least one of the control lines, and
the plurality of the control lines are located adjacent to each other in the second direction outside the region in which the plurality of photoelectric conversion parts is located.

4. The radiation detector according to any one of claims 1 to 3, wherein
a gap dimension between the second thin film transistor and the capacitance part is substantially equal to a gap dimension between the first thin film transistor and the electrode.

5. The radiation detector according to any one of claims 1 to 4, wherein
the capacitance part includes a same material as the electrode.

6. The radiation detector according to any one of claims 1 to 5, wherein
the plurality of noise detecting parts is arranged along the data line, and
a length in the first direction of the capacitance part is less than a length in the first direction of the electrode.

7. The radiation detector according to any one of claims 1 to 6, wherein
the plurality of noise detecting parts is arranged along the control line, and
a length in the second direction of the capacitance part is less than a length in the second direction of the electrode.
